Europäisches Patentamt

European Patent Office

Office européen des brevets

(11) Veröffentlichungsnummer: **0 241 065**
**A2**

(12) # EUROPÄISCHE PATENTANMELDUNG

(21) Anmeldenummer: 87200439.5

(22) Anmeldetag: 10.03.87

(51) Int. Cl.³: **H 03 B 5/20**
**G 01 L 9/04, G 01 K 7/20**

(30) Priorität: 20.03.86 DE 3609358

(43) Veröffentlichungstag der Anmeldung:
14.10.87 Patentblatt 87/42

(84) Benannte Vertragsstaaten:
DE FR GB

(71) Anmelder: Philips Patentverwaltung GmbH
Wendenstrasse 35 Postfach 10 51 49
D-2000 Hamburg 1(DE)

(84) Benannte Vertragsstaaten:
DE

(71) Anmelder: N.V. Philips' Gloeilampenfabrieken
Groenewoudseweg 1
NL-5621 BA Eindhoven(NL)

(84) Benannte Vertragsstaaten:
FR GB

(72) Erfinder: Heck, Bernd
Carsten-Reimers-Ring 35
D-2000 Hamburg 71(DE)

(72) Erfinder: Schröder, Dierk, Dr.
Vossstraat 30 a
D-2000 Hamburg 65(DE)

(74) Vertreter: Auer, Horst, Dipl.-Ing. et al,
Philips Patentverwaltung GmbH Wendenstrasse 35
Postfach 10 51 49
D-2000 Hamburg 1(DE)

(54) Harmonischer Messoszillator zur Erfassung physikalischer Parameter.

(57) Der harmonische Meßoszillator zur Erfassung unterschiedlicher physikalischer Parameter weist ein Allpaßfilter (1) auf, das eine Stromquelle (16) mit steuerbarem Verstärkungsfaktor und ein Regelglied (17) ansteuert, das mit dem Steuereingang der Stromquelle (16) verbunden ist und das dessen Verstärkungsfaktor derart steuert, daß die Amplitude der vom Meßoszillator erzeugten Wechselspannung einen konstanten Wert annimmt. Das Allpaßfilter (1) enthält eine phasenbestimmende, zweipolige Schaltungsanordnung (10) mit einem Spannungsfolger (12), dessen Eingang mit demersten Pol (9) der Schaltungsanordnung (10) und dessen Ausgang über vier in einer Brückenschaltung (28) zusammengeschaltete Widerstandselemente (29, 32) mit den Eingängen einer Differenzverstärkerschaltung (33) verbunden sind. Die vier Widerstandselemente (29, 30, 31, 32) der Brückenschaltung (28) sind in Abhängigkeit der von ihnen erfaßten, sich ändernden physikalischen Parameter in ihrem Widerstandswert veränderbar. Der Ausgang der Differenzverstärkerschaltung (33) ist über einen ohmschen Widerstand (41) mit dem ersten Pol (9) verbunden, wobei der zweite Pol (11) der zweipoligen Schaltungsanordnung (10) mit dem Verbindungsglied der beiden Widerstandselement (31, 30) der Brückenschaltung (28) verbunden ist. Eine Änderung eines Widerstandselements der Brückenschaltung (28) infolge Änderung des durch sie erfaßten physikalischen Parameter, hat eine gut meßbare Änderung der Frequenz des Meßoszillators zur Folge.

FIG.1

**BESCHREIBUNG**

Harmonischer Meßoszillator zur Erfassung physikalischer
Parameter

Die Erfindung bezieht sich auf einen harmonischen Meßoszillator zur Erfassung physikalischer Parameter, insbesondere des Drucks, der ein Signal mit von dem physikalischen Parameter abhängender Frequenz erzeugt und der
einen über ein Allpaßfilter mitgekoppelten Verstärker
enthält, wobei das Allpaßfilter ein als zweipolige
Schaltungsanordnung ausgebildetes phasenbestimmendes
Schaltungsglied mit parameterabhängigem ohmschen Meßwiderstand enthält, dessen vom Allpaßfilter erfaßbare
Widerstandsänderung bei Änderung der Parametergröße größer
als die Widerstandsänderung selbst ist.

Ein harmonischer Meßoszillator der eingangs beschriebenen
Art ist in der deutschen Patentanmeldung P 35 29 245
beschrieben, bei dem das Allpaßfilter mit einem Meßwiderstand verbunden ist, der einen temperaturabhängigen
ohmschen Widerstand aufweist. Zwar kann grundsätzlich
dieser temperaturabhängige ohmsche Widerstand durch einen
Widerstand ersetzt werden, der in Abhängigkeit von der
Änderung anderer physikalischer Parameter seinen Widerstandswert ändert, so daß der Meßoszillator ein Signal mit
parameterabhängiger Frequenz erzeugt; es hat sich jedoch
gezeigt, daß dabei die Empfindlichkeit nicht ausreicht, um
kleine Parameteränderungen genau erfassen zu können.

Es ist Aufgabe der vorliegenden Erfindung, die Empfindlichkeit des harmonischen Meßoszillators so weit zu vergrößern, daß kleine Änderungen des zu erfassenden physikalischen Parameters relativ große, gut meßbare Änderungen
der Oszillatorfrequenz ergeben.

Gelöst wird diese Aufgabe gemäß der Erfindung dadurch, daß in der zweipoligen Schaltungsanordnung vier in einer Brückenschaltung zusammenwirkende parameterveränderliche Widerstandselemente den Meßwiderstand bilden.

Das Vorsehen einer Brückenschaltung als vom Allpaßfilter erfaßbarer veränderbarer ohmscher Widerstand vergrößert die Empfindlichkeit des Meßoszillators insgesamt, so daß auch andere physikalische Parameter, beispielsweise Drücke, mit großer Empfindlichkeit erfaßt werden können.

Vorteilhafterweise enthält die zweipolige Schaltungsanordnung einen Spannungsfolger, dessen Eingang mit dem ersten Pol der Schaltungsanordnung und dessen Ausgang mit einem Pol des ersten Diagonalzweigs der vierpoligen Brückenschaltung verbunden ist, während der andere Pol des ersten Diagonalzweigs der vierpoligen Brückenschaltung mit dem zweiten Pol der zweipoligen Schaltungsanordnung verbunden ist, wobei die beiden Pole des zweiten Diagonalzweigs der Brückenschaltung jeweils mit einem Eingang einer Differenzverstärkerschaltungsanordnung verbunden sind, deren Ausgangssignal über den ersten Pol der Schaltungsanordnung den Strom im Allpaßfilter steuert. Bei Änderung des Widerstandes irgendeines der paramterveränderlichen Widerstandselemente, d.h. wenn lediglich eine Abweichung zwischen sonst gleichartigen Größen erfaßt werden soll, ist eine Differenzverstärkerschaltungsanordnung zur Erfassung dieser Änderung gut geeignet.

Gemäß einer vorteilhaften Weiterbildung der Erfindung enthält die Differenzverstärkerschaltung im wesentlichen zwei erste über ihren invertierenden Eingang rückgekoppelte Operationsverstärker, deren nichtinvertierende Eingänge jeweils mitden Polen des zweiten Diagonalzweigs der Brückenschaltung verbunden sind, und einen nachfolgenden dritten Operationsverstärker, dessen nichtinvertierender Eingang mit dem Ausgang des einen ersten
Operationsverstärkers und dessen invertierender Eingang
mit dem Ausgang des anderen Operationsverstärkers verbunden ist. Auf diese Weise wird eine kostengünstig
herstellbare Differenzverstärkerschaltung geschaffen, da
die Operationsverstärker selbst als integrierte Standardbauteile beziehbar sind, und zwar sowohl als einzelne
getrennte integrierte Bausteine, als auch in Form eines
vollständig integrierten Differenzverstärkers in einem
Baustein.

In einer weiteren Ausgestaltung der Erfindung ist die
Differenzverstärkerschaltung über ihren Ausgang mit dem
Eingang eines nicht invertierenden Verstärkers verbunden,
dessen Ausgang über einen Widerstand an den ersten Pol der
Schaltungsanordnung angeschlossen ist. Dieser nicht
invertierende Verstärker kann zur Verminderung des
Verstärkungsfaktors des Differenzverstärkers notwendig
sein, um Phasenfehler zu vermindern.

Um insbesondere Kräfte oder Drücke messen zu können, sind
die die Brückenschaltung bildenden Widerstandselemente in
Form von Dehnungsmeßstreifen ausgebildet.

Ein Ausführungsbeispiel nach der Erfindung wird nunmehr
anhand der Zeichnung näher beschrieben. Es zeigen:

Fig. 1 ein Schaltbild eines harmonischen Meßoszillators,

Fig. 2 ein Schaltbild der im Meßoszillator nach Fig. 1
verwendeten zweipoligen Schaltungsanordnung.

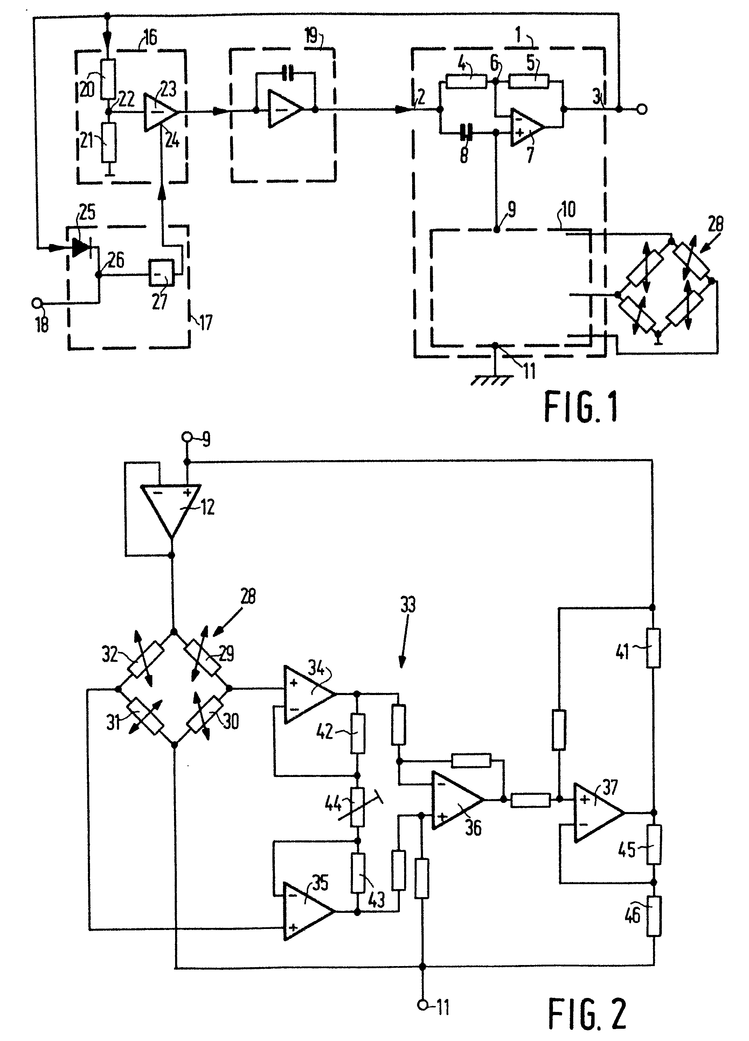

Der in Fig. 1 dargestellte harmonische Meßoszillator
enthält ein Allpaßfilter erster Ordnung 1, dessen Eingang 2 und Ausgang 3 über einen ohmschen Spannungsteiler 4, 5 miteinander verbunden sind. DerMittelabgriff 6 des ohmschen Spannungsteilers 4, 5 ist mit dem invertierenden Eingang eines Operationsverstärkers 7 verbunden, der ausgangsseitig mit dem Ausgang 3 des Allpaßfilters 1 verbunden ist. Der nichtinvertierende Eingang des Operationsverstärkers 7 ist über einen Kondensator 8 mit dem Eingang 2 des Allpaßfilters 1 und außerdem mit dem ersten Pol 9 eines zweipoligen Schaltungsgliedes verbunden, dessen zweiter Pol 11 auf Masse liegt. Das Schaltungsglied besteht aus einer zweipoligen Schaltungsanordnung 10, die mit einem Meßwiderstand 28 verbunden ist, der als vierpolige Brückenschaltung ausgebildet ist.

Die zweipolige Schaltungsanordnung 10 enthält einen Spannungsfolger 12, der beispielsweise als Operationsverstärker ausgebildet sein kann, dessen Eingang mit dem ersten Pol 9 der Schaltungsanordnung 10 und dessen Ausgang mit einem Pol des ersten Diagonalzweigs der vierpoligen Brückenschaltung 28 verbunden ist. Die vierpolige Brückenschaltung besteht aus vier Widerstandselementen 29, 30, 31, 32, die ihren ohmschen Widerstandswert bei Änderung des physikalischen Parameters, den sie erfassen, ändern. Für Kraft- bzw. Druckmessungen können die Widerstandselemente 29 bis 32 beispielsweise aus Dehnungsmeßstreifen bestehen. Der andere Pol des ersten Diagonalzweiges der vierpoligen Brückenschaltung 28 ist mit dem zweiten Pol 11 der zweipoligen Schaltungsanordnung 10 verbunden. Beide Pole des zweiten Diagonalzweigs der Brückenschaltung 28 sind jeweils mit einem Eingang einer Differenzverstärkerschaltung 33 verbunden.

Die Differenzverstärkerschaltung 33 kann grundsätzlich auf beliebige Weise aufgebaut sein, gemäß der Darstellung von

Fig. 2 enthält sie jedoch im wesentlichen zwei erste über ihren invertierenden Eingang jeweils rückgekoppelte Operationsverstärker 34, 35, deren nichtinvertierende Eingänge jeweils mit den Polen des zweiten Diagonalzweigs der Brückenschaltung 28 verbunden sind, und einen nachfolgenden Operationsverstärker 36. Dabei ist der nichtinvertierende Eingang des Operationsverstärkers 36 mit dem Ausgang des ersten Operationsverstärkers 34 und der invertierende Eingang des Operationsverstärkers 36 mit dem Ausgang des anderen ersten Operationsverstärkers 35 verbunden. Die Ausgänge der Operationsverstärker 34, 35 sind auf bekannte Weise über Widerstände 42, 43 mit ihren jeweiligen negativen Eingängen rückgekoppelt, wobei beide invertierende Eingänge beider Operationsverstärker 34, 35 durch einen einstellbaren Widerstand 44 zur Einstellung des Arbeitspunktes der Differenzverstärkerschaltung 33 verbunden sind.

Der Ausgang der Differenzverstärkerschaltung 33, d.h. in diesem Falle der Ausgang des Operationsverstärkers 36, ist mit dem Eingang eines nichtinvertierenden Verstärkers 37 verbunden, dessen Ausgang über einen Widerstand 41 an den ersten Pol 9 der Schaltungsanordnung 10 angeschlossen ist. Hierdurch wird die Verstimmung der Widerstandsmeßbrücke in einen zur Verstimmung proportionalen Strom an der Klemme 9 umgesetzt.

Der Ausgang 3 des Allpaßfilters 1 ist einerseits mit einer Stromquelle 16 und andererseits mit einem Regelglied 17 verbunden, das eine Eingangsklemme 18 zur Eingabe eines Amplitudensollwertes aufweist und das ausgangsseitig mit dem Steuereingang der Stromquelle 16 zur Steuerung des von der Stromquelle gelieferten Stromes verbunden ist. Die Stromquelle 16 ist über einen $90^{\circ}$ Phasenschieber 19 mit dem Eingang 2 des Allpaßfilters 1 verbunden. Der $90^{\circ}$

Phasenschieber 19 ist beispielsweise als kapazitiv gegengekoppelter, invertierender Operationsverstärker ausgebildet. Die Stromquelle 16 kann beispielsweise aus einem ohmschen Spannungsteiler 20, 21 bestehen, der mit dem Ausgang 3 des Allpaßfilters 1 verbunden und dessen Mittelabgriff an den invertierenden Eingang eines dritten Operationsverstärkers 23 mit Stromausgang angeschlossen ist, der einen Steuerausgang 24 zum Einstellen des Verstärkungsfaktors und damit der Größe des gelieferten Stromes aufweist.

Das Regelglied 17 erhält einen mit dem Ausgang 3 des Allpaßfilters 1 verbundenen Gleichrichter 25, der gemeinsam mit der Eingangsklemme 18 zur Eingabe des Amplitudensollwertes an einen Summationspunkt 26 angeschlossen ist. Der Summationspunkt 26 ist mit dem invertierenden Eingang einer Glättungseinrichtung 27 verbunden, die den negativen, linearen Mittelwert der über den Summationspunkt 26 gelieferten Wechselspannung ermittelt und über den Steuerausgang dem Operationsverstärker 23 zuführt. Die Glättungseinrichtung 27 kann beispielsweise als Integrierglied mit invertierendem Eingang ausgebildet sein.

Der harmonische Meßoszillator besteht also im wesentlichen aus einem Verstärker 16, der über ein Allpaßfilter 1 mitgekoppelt ist und dadurch mit einer von den Widerstandswerten des phasenbestimmenden Kondensators 8 und des phasenbestimmenden Schaltungsglieds 10, 28 abhängigen Frequenz schwingt. Die Amplitude der vom harmonischen Meßoszillator gelieferten Wechselspannung wird vom Regelglied 17 derart geregelt, daß sie einen konstanten Wert annimmt. Hierzu wird die vom Allpaßfilter 1 gelieferte Wechselspannung im Gleichrichter 25 gleichgerichtet. Zu der vom Gleichrichter 25 erzeugten welligen Gleichspannung wird im Summationspunkt 26 die über die Eingangsklemmen 18 eingegebene und dem Amplitudensollwert entsprechende Gleichspannung mit negativer Polarität addiert. Die Glättungseinrichtung 27 mit invertierendem Eingang erzeugt aus der sich dadurch ergebenden Wechselspannung eine negative bzw. positive Gleichspannung, die dem Steuereingang 24 des Operationsverstärkers 23 zugeführt wird und die dessen Verstärkungsfaktor verkleinert bzw. vergrößert, wenn die Amplitude der vom Allpaßfilter 1 gelieferten Wechselspannung größer bzw. kleiner als der vorgegebene Amplitudensollwert ist.

Die in der zweipoligen Schaltungsanordnung 10 enthaltene Differenzverstärkerschaltung 33 erzeugt aus der am nichtinvertierenden Eingang des Operationsverstärkers 7 und damit einerseits an der einen Klemme des Widerstandes 41 und andererseits über den Spannungsfolger 12 über die Widerstandselemente 29, 32 der Brückenschaltung 28 anliegenden Wechselspannung eine dazu gegenphasige Wechselspannung, die an der anderen Klemme des Widerstandes 41 anliegt. Von der Differenz der an den beiden Klemmen des Widerstandes 41 anliegenden Spannung unterschiedlicher Polarität ist der durch den Widerstand 41 fließende Strom und damit der gesamte in die Schaltungsanordnung 10 einfließende Strom abhängig. Wird die Brückenschaltung 28 verstimmt, d.h. ändert sich der Widerstandswert der Brückenschaltung 28 in Abhängigkeit von der Veränderung des durch die Brückenschaltung 28 erfaßten physikalischen Parameters, so wird durch Änderung des Ausgangssignals der Differenzverstärkerschaltung 33 die am Widerstand 41 anliegende Wechselspannung verändert, in deren Folge der in die Schaltungsanordnung 10 einfließende Strom sich ändert.

Eine Zunahme dieses Stromes ist aber gleichbedeutend mit einer Abnahme des ohmschen Widerstandes der Schaltungsanordnung 10. Die Frequenz der vom harmonischen Meßoszillator erzeugten Wechselspannung ist umgekehrt proportional zum ohmschen Widerstand des Schaltungsgliedes 10, 28 und damit proportional zu dem von der Brückenschaltung 28 zu erfassenden physikalischen Parameter.

Zwischen dem Ausgang des Operationsverstärkers 36 und dem Widerstand 41 kann noch ein nichtinvertierender Verstärker 37 geschaltet sein, dessen Verstärkungsfaktor sich durch entsprechende Dimensionierung der Widerstände 45 und 46 einstellen läßt. Durch Veränderung des Widerstandes 41 läßt sich auch der Strom einstellen, so daß dadurch der ohmsche Widerstand des zweipoligen Schaltungsgliedes 10 und damit auch die Frequenz der vom harmonischen Meßoszillator erzeugten Wechselspannung eingestellt werden kann.

PATENTANSPRÜCHE

1.   Harmonischer Meßoszillator zur Erfassung physikalischer Parameter, insbesondere des Drucks, der ein Signal mit von dem physikalischen Parameter abhängenden Frequenz erzeugt und der einen über ein Allpaßfilter mitgekoppelten Verstärker enthält, wobei das Allpaßfilter ein als zweipolige Schaltungsanordnung ausgebildetes phasenbestimmendes Schaltungsglied mit parameterabhängigem ohmschen Widerstandswert erhält, dessen vom Allpaßfilter erfaßbare Widerstandsänderung bei Änderung der Parametergröße größer als die Widerstandswertänderung selbst ist, dadurch gekennzeichnet, daß in der zweipoligen Schaltungsanordnung (10) vier in einer Brückenschaltung (28) zusammenwirkende parameterveränderliche Widerstandselemente (29, 30, 31, 32) den Meßwiderstand bilden.

2.   Meßoszillator nach Anspruch 1, dadurch gekennzeichnet, daß die zweipolige Schaltungsanordnung (10) einen Spannungsfolger (12) erhält, dessen Eingang mit dem ersten Pol (9) der Schaltungsanordnung (10) und dessen Ausgang mit einem Pol des ersten Diagonalzweigs der vierpoligen Brückenschaltung (28) verbunden ist, während der andere Pol des ersten Diagonalzweigs der vierpoligen Brückenschaltung (28) mit dem zweiten Pol (11) der zweipoligen Schaltungsanordnung (10) verbunden ist, wobei die beiden Pole des zweiten Diagonalzweigs der Brückenschaltung jeweils mit einem Eingang einer Differenzverstärkerschaltung (33) verbunden sind, deren Ausgangssignal über den ersten Pol (9) den Strom im Allpaßfilter (1) steuert.

3.      Meßoszillator nach Anspruch 2,
dadurch gekennzeichnet, daß die Differenzverstärkerschaltung (33) im wesentlichen zwei erste über ihren
invertierenden Eingang rückgekoppelte Operationsverstärker (34, 35), deren nichtinvertierende Eingänge
jeweils mit den Polen des zweiten Diagonalzweigs der
Brückenschaltung (28) verbunden sind, und einen nachfolgenden dritten Operationsverstärker (36) enthält,
dessen nichtinvertierender Eingang mit dem Ausgang des
ersten Operationsverstärkers (34) und dessen
invertierender Eingang mit dem Ausgang des anderen ersten
Operationsverstärkers (35) verbunden sind.

4.      Meßoszillator nach Anspruch 2 oder 3,
dadurch gekennzeichnet, daß die Differenzverstärkerschaltung (33) über ihren Ausgang mit dem Eingang eines
nicht invertierenden Verstärkers (37) verbunden ist,
dessen Ausgang über einen Widerstand (41) an den ersten
Pol (9) der Schaltungsanordnung (10) angeschlossen ist.

5.      Meßoszillator nach Anspruch 1 bis 4,
dadurch gekennzeichnet, daß die die Brückenschaltung (28)
bildenden Widerstandselemente (29, 30, 31, 32) Dehnungsmeßstreifen sind.

FIG.1

FIG. 2